# EUROPEAN PATENT SPECIFICATION

(11) **EP 2 273 568 B1**
(45) Date of publication and mention of the grant of the patent: **29.05.2013**
(21) Application number: 09737619.8
(22) Date of filing: 06.03.2009
(51) Int. Cl.: H01L 33/00, F21K 99/00

(54) **WHITE LIGHT LED AND LAMP OF THE WHITE LIGHT LED**
WEISSLICHT-LED UND LAMPE MIT WEISSLICHT-LED
LED À LUMIÈRE BLANCHE ET LAMPE COMPORTANT LA LED À LUMIÈRE BLANCHE

(30) Priority: 30.04.2008 CN 200810094414
(43) Date of publication of application: 12.01.2011
(73) Proprietor: Zhejiang Manelux Lighting Co., Ltd., Fuyang, Zhejiang 311404 (CN)
(72) Inventor: GUO, Bangjun, Zhejiang 310012 (CN); LOU, Mane, Zhejiang 310012 (CN)
(74) Representative: Witte, Weller & Partner
(86) International application number: PCT/CN2009/000238
(87) International publication number: WO 2009/132508

(56) References cited:
- WO-A1-2006/126802
- WO-A2-2006/077488
- CN-Y- 2 396 512
- CN-Y- 2 833 896
- JP-A- 2002 133 932
- JP-A- 2004 264 370
- JP-A- 2007 123 484
- US-A- 1 915 842
- US-A- 5 483 424
- US-A1- 2003 025 117
- US-A1- 2006 018 118
- US-A1- 2007 247 855
- US-A1- 2009 244 903
- US-B1- 6 184 628
- US-B1- 6 200 002

## Description

### Background of the Invention

### Technical Field

The present invention relates to a white light emission diode (LED), especially to a white LED lamp using the white LED with high color rendering index (CRI), which is produced by placing at least 6 LED chips emitting lights at different wavelengths as an electrical combination together into a reflector which mixes the lights. Document US2007//0247855 discloses a LED according to the preamble of claim 1.

### Brief Description of the Related Art

The current commercially available white LED is produced by coating a blue light chip with phosphors, where the blue light is emitted from a LED chip with emitting wavelengths of 455∼465nm and the phosphors which have absorbed the blue light emit yellow green light. The CRI of the white LED is not high due to absence of red light component in its luminescence. Therefore, the white LED is not qualified to replace general lighting source.

The proposed methods for fabricating white LED also include the following:
A. A combination of three LED chips emitting red, green and blue lights is made and the three-color lights are mixed to form a white light by a color mixing agent. Since each LED chip emits one-color light in full width of about 20nm at half maximum power, and the color mixing agent can mix lights only, instead of changing light spectrum compositions. As a result, the emission spectrum of the combination shows three discrete emission peaks. The discontinuous emission spectrum is difficult to give a high CRI, accordingly, the combination is difficult to give a high CRI light source. Meanwhile, the color mixing agent induces diffuse reflection leading to a serious light loss.
B. Another designing method was proposed in June of 1998 (reference CN1185042A), where a desired CRI is given, and then color coordinates are calculated out based on colorimetry. Based on the calculated results, a system including three or four LED chips is designed, in which an emission wavelength and an emission intensity from each chip are given subsequently. However, the designing method is not used in practical fabrication of white LED. The reasons are:
   1) The designing method is available only in case that the number of chip types is not more than 4. Once it is larger than 4, there will be no certain solutions to satisfy the designing. In the case of 4 types of chips, it is difficult to get high CRI.
   2) The emission wavelengths solved based on the designing method are not the emission wavelengths of the LED chips that can be produced in mass production. As a matter of fact, LED chips fabricated at present in mass production cannot give an expected CRI. In addition, the reference fails to disclose any technical solutions on how to mix several lights to form the white light.
   3) Further, the patent literature does not illustrate any specific LED structures. Therefore, any practical technical solutions for white LED can not be derived from the reference.
C. The third method involves in producing white LED by using ultraviolet (UV) light to excite three-primary-colors phosphors. In principle, the method is similar to a phosphor lamp. However, this method is disadvantageous in the following aspects. First, it is difficult to avoid leakage of an UV light to the out space of the device due to use of the UV light. The leaked UV light may hurt eyes of persons around the manufacturing facilities. Secondly, the efficiency of exciting the three-primary-colors phosphors is low because wavelength of current UV LED used for exciting phosphors is rather long and the electro-optic conversion efficiency is low. As a result, the luminous efficiency of the white LED is low in total, and thus the method cannot be put into practice.

### Summary of the Invention

The object of the invention is made to overcome at least one aspect of the disadvantages in the prior arts. More particularly, the present invention is made to solve the problem that CRI is low and the difference between emission spectrum and the standard light spectrum is rather large due to absence of red composition in white LED fabricated using the combination of a blue light and phosphors.

Accordingly, an object of the present invention is to provide a white LED with high CRI and a high luminous efficiency, in which 6 or more types of LED chips emitting lights at different wavelengths are fixed and electrically combined on a top surface of a heat conducting base. The lights at different wavelengths are mixed uniformly by a reflector which performs a function of mixing light uniformly through a light diffuse reflection on its inner surface on which protrusions are provided to enhance the diffuse reflection.

The another object of the invention is to fabricate white LED lamp and a LED plane lighting source for indoor lighting using the high CRI white LED according to the present invention. The white LED lamp and the LED plane lighting source avoid energy loss in phosphors for light colors conversion, so the white LED lamp and the LED plane lighting source possess a high electro-optic conversion efficiency and a long lifetime, and are suitable for mass production.

The object of the invention is realized by at least one aspect of the followings:

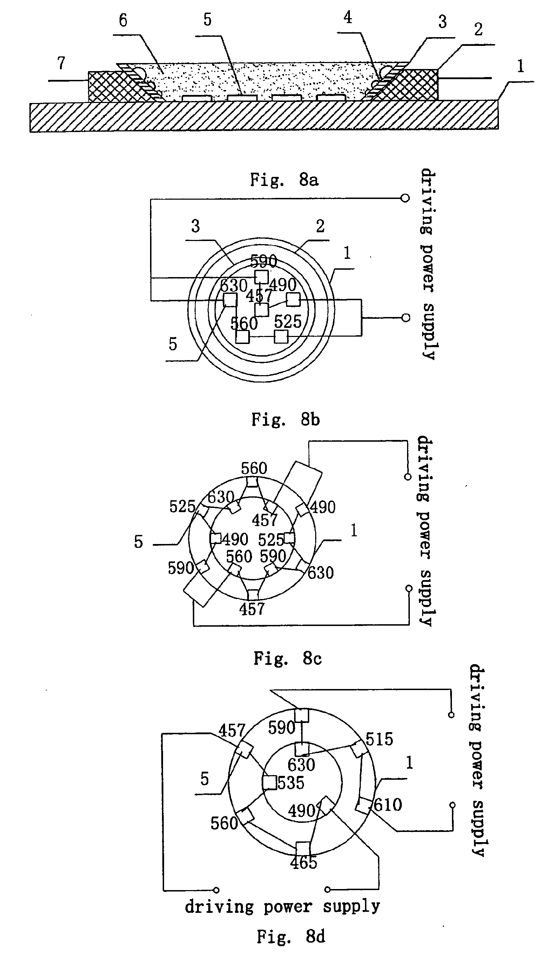

According to an aspect of the present invention, there is provided a white LED with high CRI (as shown in Fig.8a), comprising: a heat conducting base, a lead frame, a reflector fixed on the top surface of the heat conducting base, LED chips fixed on the heat conducting base within the reflector, and a transparent silicone covering the LED chips, wherein the reflector is a conical cup which has an open bottom. The lead frame is matched well with the bottom of the reflector in shape and size, and is fixed outside of the bottom of the reflector and fixed on the top surface of the heat conducting base. There are spherical protrusions on an inner wall surface of the reflector. The protrusion surface is smooth and gives a high reflectivity. The LED chips comprise at least 6 types of chips emitting lights at different wavelengths, and the number of each type of chips is at least one, in which two adjacent emitting wavelengths of chips have an interval of 35-20nm. Electrical connections of the chips may be in series, in parallel or their combination. The electrodes on the chips are electrically connected with wirings on the lead frame.

In a specific embodiment, the wavelengths of the 6 types of LED chips emitting lights at different wavelengths are 457nm (blue light chip), 490nm (blue-green light chip), 525nm (green light chip), 560nm (yellow-green light chip), 590nm (orange light chip) and 630nm (red light chip). Each LED chip is configured for each wavelength. The 6 types of LED chips are arranged on the heat conducting base in such a manner that the lights at different wavelengths can be mixed and interleaved well. Electrical connections of the chips may be in series, in parallel or their combination. In the series-parallel connection, voltage differences in two parts connected in parallel are necessarily equal. Fig.8b shows a connection way, in which three chips connected in series are in one group and such two groups are electrically connected in parallel. Each group (three chips in series) is driven by each independent power supply, or the six chips are electrically connected in series. Other connection ways are possible and can be determined by the user as required.

In a preferred embodiment, each of the six types of LED chips may contain two chips arranged on the top surface of the heat conducting base. The twelve chips are arranged in a stagger way alternately to realize a better mixing of the lights. The twelve chips are separated into two groups averagely and the 6 chips in each group are in series. Since the numbers of chips are same in the two groups, the two groups have a same voltage difference. Thus, the two groups are connected in parallel (as shown in Fig.8d). The currents passing through the two groups respectively are equal. In this way, the LEDs can emit white light in high uniformity and double the output power compared with those using 6 LED chips as shown in Fig.8b.

In a specific embodiment, the LED chips may contain 9 or 11 types of chips emitting lights at different wavelengths to allow the light spectrum energy profile to be even smooth and more close to that of a standard lamp, such as using 9 types of LED chips for the wavelengths of 457nm, 465nm, 490nm, 515nm, 535nm, 560nm, 590nm, 610nm and 630nm respectively in which each type for each chip. The arrangement and the electrical connection of these chips on the heat conducting base are shown in Fig.8d. The positions of the chips are arranged in such a manner that the lights can be mixed well. The 9 types of LED chips emitting lights at different wavelengths are divided into two unequal groups for their electrical connections. One group is composed of 5 types of LED chips emitting lights at different wavelengths in series, which emit lights that are closer to the blue light. The other group is composed of 4 types of LED chips emitting lights at different wavelengths in series, which emits lights that are closer to the red light, as shown in Fig.8d. Since the numbers of LED chips in the two groups are unequal, two separated driving power supplies are needed for the two groups.

In a specific embodiment, the LED chips may be a power-type chip, or may be composed of several small chips. The total number of the chips is determined by the power as required and that electrical power applicable to each chip, which can be realized by the ordinary skilled person in the art.

In a preferred embodiment, the heat conducting base may be a plate base made of copper, aluminum or composite materials, a base provided with a screw or screw hole on its bottom surface, and a base provided with radiation fins or super heat conducting pipes. The radiation fins are spiral radiation fins with one or more spirals or a type of radiation assembly.

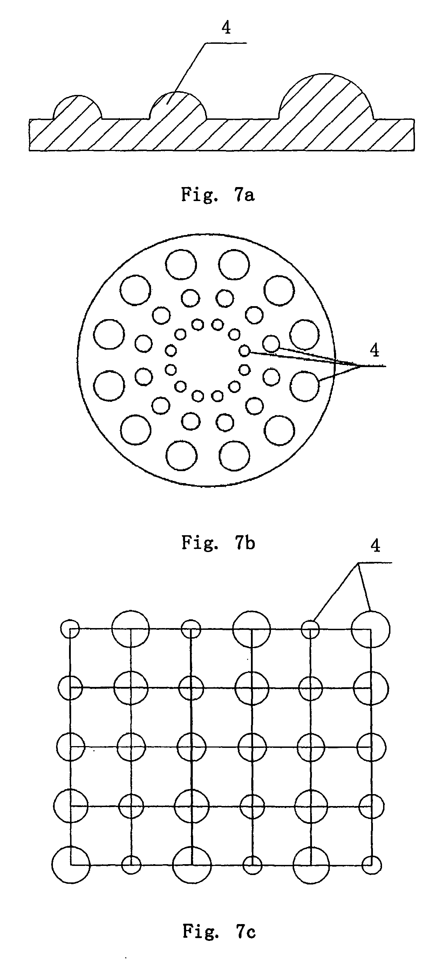

In a preferred embodiment, the reflector for mixing light is made of metal materials such as copper or aluminum. For the purpose of the light mixing, the protrusions may have same or different sizes. The protrusions are arranged in stagger way in alternate lines, in arrays or in uniform pattern in descending order of sizes, as long as the emitting angle and uniformity of the emitted light can meet the requirements of use. Fig.7b and Fig.7c show two typical arrangements respectively.

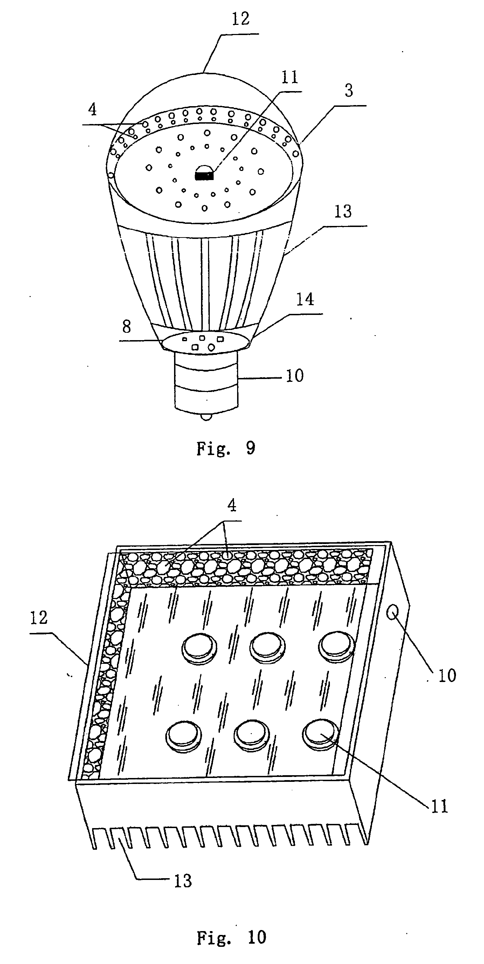

The invention also provides a white LED lamp as shown in Fig.9, which is designed based on the white LED described in the invention. The white LED lamp comprises at least one white LED that is connected and contacts mechanically with a heat sink directly through a screw or a screw hole. The LED is wired with a driving circuit, and the driving circuit is connected with an electrical connector through its housing. A transparent bubble shell covers the LED. The bottom of the heat sink is connected with a cup-shaped plastic member, and a driving power supply is accommodated in an inner space of the plastic member. The plastic member ensures a good electrical insulation between the driving power supply and the heat sink. An end of the plastic member is provided with an electrical connector. The reflector used in the LED is fixed at a top end of the heat sink. There are protrusions on inner wall surface of the reflector to achieve a uniform light mixing.

In a particular embodiment, the electrical connector is a bayonet socket in double or multiple feet or a screw socket, which may be an international standard E27 or E14 screw-socket, or other interfaces.

In a preferred embodiment, the transparent bubble shell is made of glass or plastics and is transparent, colored or diffused.

In a specific embodiment, there are light converting materials in an inner wall surface of the transparent bubble shell.

The invention provides a LED plane light source for indoor lighting using the white LED according to the present invention. The LED plane light source includes at least one of the LEDs, a heat sink, a driving circuit, an electrical connector and a transparent bubble shell, wherein the heat sink is produced by providing 2 or 4 reflecting walls on a heat dissipation plate. The heat dissipation plate is provided with fins on its bottom surface. The reflecting walls are provided with protrusions on its inner surface. An electrical connection plughole arranged on outside the reflecting walls is connected to the driving power supply. The transparent bubble shell is fixed on the reflecting walls as an independent plane light source, or as a combination of two or more LED plane light sources. The LED is a white LED with high CRI.

The white LED with high CRI according to the present invention has the following advantages:
1. In an embodiment, at least 6 types of LED chips emitting lights at different wavelengths are fixed and electrically combined on a heat conducting base, the emitted lights at different wavelengths are mixed uniformly by the diffuse reflection of the reflecting wall of the reflector which is in a shape of cone or truncated cone having an open bottom and which is provided with protrusions on the inner wall surface so as to produce the white LED and white LED lamp with high efficiency and high CRI. Since the energy distribution of the spectrum of the white LED or white LED lamp is close to that of a standard lamp, it contains a full spectra that a person's eyes is sensitive to, accordingly, the white LED has a good effect of mixing light, high CRI and low light loss.
2. The white LED according to the present invention has a high light emitting efficiency. The current prevalent method for producing a white LED uses phosphors having absorbed a blue light to emit a yellow green light. In this process, a certain energy loss will generated. In contrast, the present invention does not use phosphors, and thus the energy loss is avoided. Furthermore, as an inventive method for light mixing is employed, a high light emitting efficiency is achieved.
3. The white LED according to the present invention has a low optical attenuation and a good optical consistency. For a white LED produced by the current method, its attenuation includes substantially a mixture of the attenuation of chips emitting and the attenuation of the phosphors. However, the white LED according to the present invention is produced independently of phosphors, and thus, its spectrum chromaticity is completely dependent on the spectrum chromaticity for chips and light mixing effects. Therefore, as long as the wavelength for each type of chips chosen is consistent in the mass production, the emitted light will have a consistent spectrum chromaticity.
4. Customized lightings can be realized using the white LED or white LED lamp according to the present invention. By adjusting forward currents in each type of chips, an outputted light intensity can be changed, and thus a correlated color temperature of the light emitted by the white LED or white LED lamp can be adjusted to a monochromatic light.

### Brief Description of the Drawings:

Fig.1 shows the energy distribution of the spectrum of an international standard lamp A light source, where its color temperature is 2856°K.
Fig.2 shows the energy distribution of the spectrum of an international standard lamp D65 light source, where its color temperature is 6504°K.

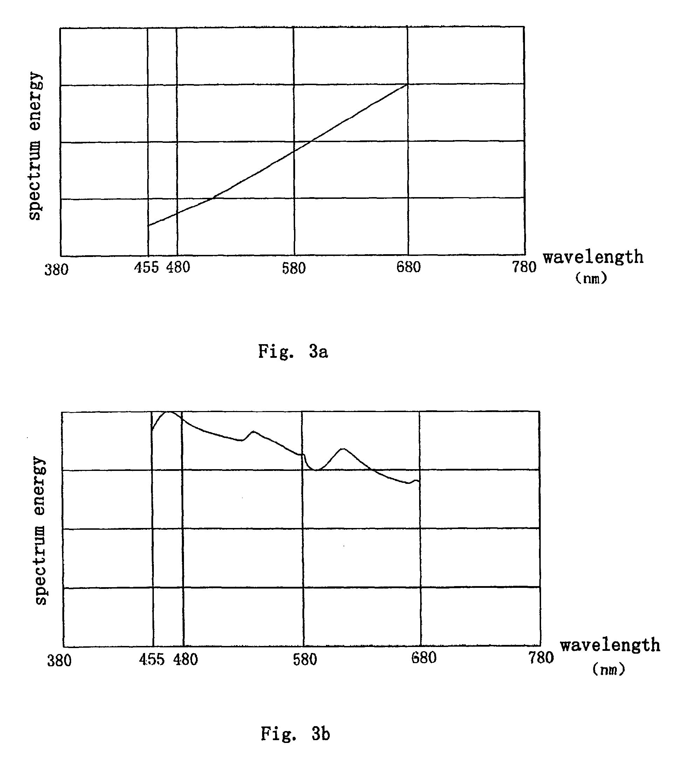

Fig.3a shows the energy distribution of the spectrum of a light source of the standard lamp A within the wavelength band chosen depending on the person's eyes sighting function.
Fig. 3b shows the energy distribution of the spectrum of the light source of the standard lamp D65 within the wavelength band chosen depending on the person's eyes sighting function.
Fig.4 shows energy distribution of spectra of the three types of LED chips of red, green and blue lights.
Fig.5 shows energy distribution of spectra of the 6 types of LED chips according to the present invention.
Fig.6 shows the energy distribution of the spectrum of the mixed light from the 6 type of LED chips according to the present invention.
Fig.7a is a cross-section view of an arrangement of the protrusions on the inner wall surface of the reflector.
Fig.7b is a top view of another arrangement of the protrusions on the inner wall surface of the reflector.
Fig.7c is a schematic view of the third arrangement of the protrusions on the inner wall surface of the reflector.
Fig.8a is a cross-section view of a structure of the white LED with high CRI according to the present invention.
Fig.8b is a schematic view of an arrangement and an electrical connection of 6 types of the LED chips on the heat conducting base (unit of the wavelength for the chips is nm in Fig. 8b).
Fig.8c is a schematic view of an arrangement and an electrical connection of 6 types of the LED chips on the heat conducting base, where each type of LED chips contain 2 chips (unit of the wavelength for the chips is nm in Fig. 8c).
Fig.8d is a schematic view of an arrangement and an electrical connection of 9 types of the LED chips on the heat conducting base (unit of the wavelength for the chips is nm in Fig. 8d).
Fig.9 is a schematic view of a structure of the white LED lamp according to the present invention.
Fig.10 is a schematic view of a structure of the plane white LED lamp produced by using the white LEDs with a high CRI according to the present invention.

In the drawings, the following components are designated by the reference numerals as below:
1-heat conducting base
2-lead frame
3-reflector
4-protrusion
5-LED chip
6-transparent silicone
7-lead out strip of LED electrode
8-driving circuit
10-electrical connector
11-LED light source
12-transparent bubble shell
13-heat sink
14-plastic member
3'-reflecting cover
4'-projection

Embodiments of the present invention will be described, by way of example only, with reference to the accompanying drawings. However, it is not intended to limit the invention to the specific embodiments.

### Detailed Description of the Preferred Embodiment

The present invention provides a method for fabricating high CRI white LED. Embodiments of the method will be illustrated next with reference to the drawings. The three -digit numbers in Figs.8a-Fig.8d indicate the wavelengths of the chips. In Figs.8a-Fig.8d, the unit of the wavelengths which is nm is omitted for brevity.

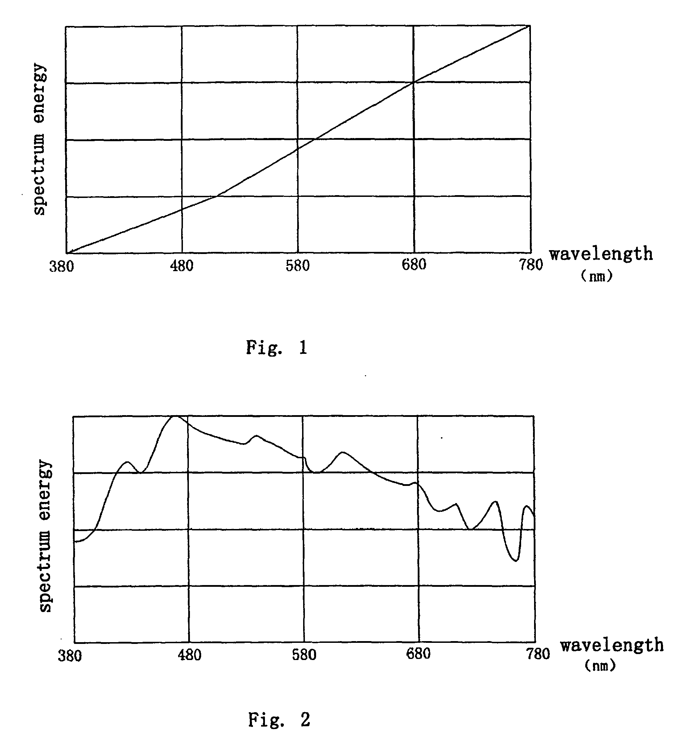

The CRI of a light source is a physical parameter to evaluate the color rendition property of the light source to an object irradiated by the light source. Sun-light is the light source with the best CRI because its spectrum is continuous throughout the wave band of the visible light. In an artificial light source, it may be considered that the internationally specified standard lamps have the best CRI. The standard lamps emit lights with continuous spectra but different color temperatures due to different energy distributions of the spectra. Figure 1 shows the energy distribution of the spectrum of a standard light source D65 within the visible band.

Figure 2 shows the energy distribution of the spectrum of a standard light source A. To fabricate the LED with high CRI, it is necessary for the LED to emit a light which substantially has a continuous energy distribution of spectrum being close to that of a standard lamp. However, the standard lamp has a quite wide band of the spectrum, including a range of 380nm ∼ 780nm in the visible band. It is difficult and not necessary for the LEDs to meet the above requirement for a width of the spectrum because person's eyes are only sensitive to lights at wavelengths of 450nm ∼ 700nm. Based on the sensitivity range of the person's eyes and the LED emitting wavelength range, the wavelength band of 455nm∼ 680nm are chosen as a reference wavelength band for the fabrication of the high CRI white LED.

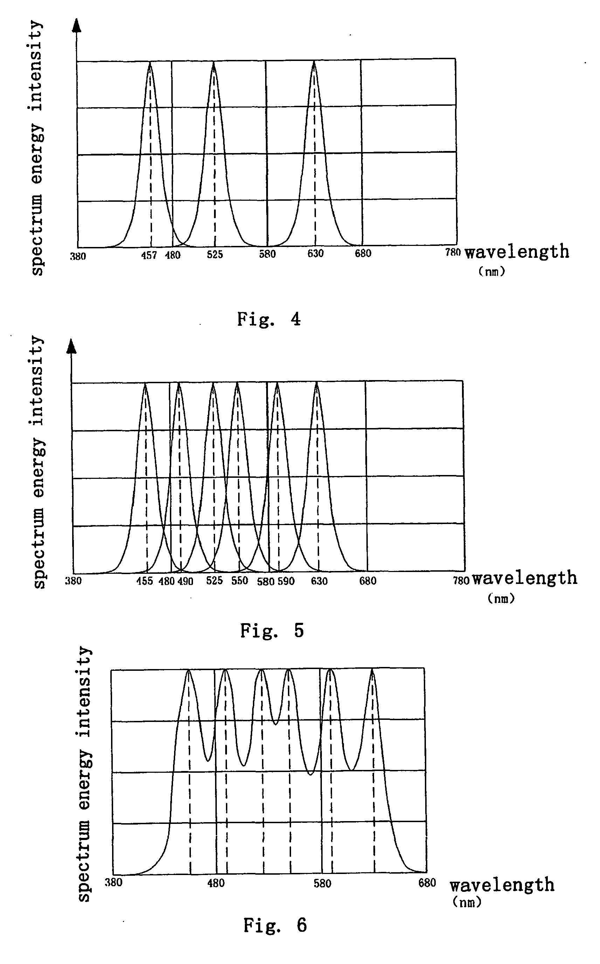

The spectrum of the conventional R, G, B three-color light is shown in Fig.4, in which any two peaks have a large interval so that the spectrum can not be continuous. The spectrum for the LED chip contains a peak wavelength at which the LED chip emits a light with a peak value of output power. The spectrum for the LED chip also comprises a first wavelength range having two ends at which the LED chip emits a light with about half of the peak value of output power and a second wavelength range having two ends at which the LED chip emits a light with about 1/4 of the peak value of output power. The first wavelength range typically has a maximum wavelength which is about 10 nm more than the peak wavelength and a minimum wavelength which is about 10 nm less than the peak wavelength. The second wavelength range typically has a maximum wavelength which is about 18 nm more than the peak wavelength and a minimum wavelength which is about 18 nm less than the peak wavelength. For example, a red LED chip with a peak wavelength of 630nm has the first wavelength range of 620nm∼640nm and the second wavelength range of 612nm∼648nm.

On basis of the above characteristics of the LED chip , a continuous spectrum may be formed. For example, if a LED chip with the peak wavelength of 630nm has an output power of 1.0 at the wavelength of 630nm, its output power will become 1/4 at the wavelength of 612nm. In addition, if another LED chip with the peak wavelength of 594nm has an output power of 1.0, its output power will become 1/4 at the wavelength of 612nm. As such, if the lights emitted by the two LED chips are combined, the total output power of the two LED chips at the wavelength of 612nm will become 1/2 of the output power at the wavelength of 630 nm or 594 nm. In the case, the energy distribution of the spectrum is continuous in a zigzag shape, although it is not a straight line in a horizontal direction. The wavelength band between 455nm and 680nm has a width of 225nm. If different types of LED chips emitting lights at different wavelengths are arranged in the wavelength band at an interval of 20nm, 11 types of LED chips are needed. However, in fact, it is not necessary to use so many chips because the energy distribution of the spectrum of a standard lamp with a certain correlated color temperature is not a horizontal line. Therefore, the interval of wavelength can be adjusted as required. If the interval is 35nm, 6 types of LED chips emitting lights at different wavelengths will be enough to form a continuous spectrum in zigzag shape. For example, 6 types of LED chips with the emitting wavelengths of 457nm, 493nm, 529nm, 565nm, 601 nm and 640nm respectively may be used at the interval of 35nm.

In an embodiment, considering that wavelength for the LED chips fabricated in mass production in chip manufacturers is customized, the peak wavelengths for the 6 types of chips may be selected as 457nm, 490nm, 525nm, 560nm, 590nm and 630nm, respectively. Although they are a little difference from the above desired value, it is within in the allowable range in practice. Except the interval of 40nm between 630nm and 590nm, the intervals between other adjacent peak wavelengths are less than 35nm, and thus can have superposed second wavelength ranges for 1/4 of the peak value of output power. That is, in the case that the 6 types of chips emit lights simultaneously and have same output powers at the respective peak wavelengths, the output powers of the lights from adjacent two types of chips can be superposed at the wavelengths that are 18nm from the respective peak wavelengths and the total output powers at the wavelengths are equal to the sum of the output powers of the adjacent two types of chips at the wavelengths. The energy distribution of the spectrum composed in this way is a continuous zigzag curve. If more than 6 types of chips emitting lights at different wavelengths are used, the intervals between the peak wavelengths will become smaller and the energy profile of the light spectrum becomes more straight and smooth. But use of too many types of the LED chips may entails sophistication of the fabrication. Fig.8d shows an arrangement of the combination of 9 types of the LED chips.

To fabricate white LEDs with high CRI, a further problem to be solved is to adjust energy distributions among different chips. In the present invention, two methods are provided to adjust the energy distribution at respective wavelengths as follows:
1. to adjust the number of the chips with the same peak wavelength, for example, to imitate the D65 light source, the number of the chips with short peak wavelengths may be larger than that of the chips with long peak wavelengths; to imitate the A light source, the number of the chips with long peak wavelengths may be larger than that of the chips with short peak wavelengths.
2. to control the output powers of the chips by adjusting chip currents. The emitting light energy of a LED chip is proportional to the forward current passing through it in a wide current range after it turns on forwardly. Accordingly, the emitting light energy of the LED chip can be adjusted by changing the forward current passing through the LED chip. During adjusting the forward current, the current typically is not more than the nominal current of the LED chip. Typically, a direct current (DC) modulation or a pulse width modulation may be used to adjust the chip current.

The third problem to be solved in fabrication of the white LEDs with a high CRI involves with color mixing. The traditional color mixing method is to apply a great deal of diffuse reflection agents above a chip to allow repeated scattering of the light in the chip-contained cavity to achieve the effect of light mixing. Because the diffuse reflection is in disorder, the light loss becomes very serious and thus electro-optic conversion efficiency becomes significantly low. To solve the above problem, a plurality of protrusions, which contain a part of a sphere and have smooth surfaces with a high reflectivity, are provided on the smooth inner wall surface of the reflector to achieve the effect of both light reflection and light mixing. Depending on the light mixing, the protrusions may have same or different sizes, and it may be arranged in stagger way in a descending order of sizes. Fig.7b and Fig.7c show two typical arrangements of the protrusions.

A power-type LED chip has a light-emitting area of about 1 square millimeter. In short distance or space, the power-type LED chip can not be considered as a point light source, but as a plane light source. Each of the protrusions on the reflecting surface is illuminated by the lights coming from various directions, and then the lights are reflected back by the protrusions according to the reflection law. Thus, each of the protrusions can be taken as a point light source, which emits lights outward from the top and sides of the protrusions. With this configuration, the lights with various wavelengths can be mixed well by the protrusions and light intensity loss can be reduced to achieve a high efficiency of light mixing.

### Embodiment 1

Referring to Fig.8a-Fig.8b, a white LED with high CRI according to the present invention and a method of producing the same will be further described.

In the embodiment, the heat conducting base 1 may be a plate-shape base made of e.g., metal such as copper or aluminum, or composite materials, which may be provided with radiation fins. The radiation fins may be spiral radiation fins with one or more spirals. The base herein may be similar to the base disclosed in the Chinese patent application No. 02826127.5 or may be any of commercially available LED bases. The heat conducting base 1 may also be a radiation assembly which is composed of a support made of high-thermal conductivity materials, top radiation ribs arranged on the top of the support and a group of lower radiation ribs surrounding the support. The support may be a super heat conducting pipe, a metal pipe or a metal rod. The radiation ribs are provided with a through hole in its center. The through hole has a diameter that is equal to outer diameter of the super heat conducting pipe, the metal pipe or the metal rod. The inner diameter of the super heat conducting pipe or the metal pipe may be capable of being fitted to or matched with the screw on the bottom surface of the heat conducting base of the LED. A porous or net-like housing made of insulating materials or metals may enclose the support and may be a part of the support.

The reflector 3 for light mixing is usually made of silvered copper or aluminum. It may be a cup having a shape of a cone or a truncated cone with an open bottom. There are protrusions 4 arranged downward from top edge of the reflector along the inner wall surface (as shown in Fig.7a). The protrusions 4 may be arranged in a descending order of diameters (as shown in Fig.7b). The protrusions 4 may also be arranged in arrays (as shown in Fig.7c), or in stagger way in alternative lines. The reflector 3 is fixed on top surface of the heat conducting base 1 and is arranged in the lead frame 2. The angles between the reflector 3 and the heat conducing base 1 may be 10°-80°. The protrusion 4 contains a spherical smooth surface, and thus the inner wall surface of the reflector is smooth and has a high reflectivity.

In the embodiment, 6 commercially available LED chips, which have intervals of about 35nm for the peak wavelengths between two adjacent chips, are used. In particular, their peak wavelengths may be about 457nm, about 490nm, about 525nm, about 560nm, about 590nm and about 630nm respectively. The 6 LED chips 5 are electrically connected via wires, e.g., either in series or in parallel totally.

In the embodiment, the three chips with the peak wavelengths of 457nm, 490nm and 525nm are connected in series as a group, and the other three are also connected in series to form another group. Each of the two groups may have two lead terminals at both ends respectively. The arrangement and electrical connection of the 6 chips are shown in Fig.8b, in which the two groups are electrically connected in parallel and the lead terminals may be connected to driving circuit 8. Otherwise, the two groups may be independently driven by two power supplies instead of being connected in parallel or may be connected in series. Other suitable connections are also possible depending on the requirements of the user.

Compared with the conventional RGB white LED, in the embodiment, the LED chip with the peak wavelength of 490nm is added between the blue light chip with the peak wavelength of 457nm and the green light chip with the peak wavelength of 525 nm, and at least the LED chip with the peak wavelength of 560nm and the LED chip with the peak wavelength of 590nm chips are added between the green light chip with the peak wavelength of 525 nm and red light chip with the peak wavelength of 630 nm. A continuous light spectrum can be formed instead of separated peaks, when the 6 chips with the intervals of about 35nm for the peak wavelengths between the two adjacent chips emit lights simultaneously (see Fig.5 and Fig.6).

The above mentioned 6 LED chips 5 are arranged on top surface of the heat conducting base 1. The electrodes of the 6 chips 5 combined electrically are led out from the lead frame 2. The lead frame 2 is a copper-embedded plastics or MPCB plate. The lead frame 2 has a copper-embedded strip as a LED electrode lead out strip 7, which connects electrically the LED electrodes to the driving circuit 8. The copper-embedded strip in the lead frame 2 is electrically insulated from the heat conducting base 1. The lead frame 2 is arranged outside the reflector 3. The LED chips 5 are covered with a transparent silicone 6.

The electrodes of the 6 chips can be led out solely or in groups, to adjust output intensities of the respective chips in order to achieve the desired color of lights. These modifications or variations are also anticipatable by the skilled person in the art. The total energy distribution of the spectrum of the 6 LED chips used in the embodiment is shown in Fig.6.

Referring to Fig.8c, another embodiment of the white LED with high CRI is shown. In the embodiment, twelve LED chips 5 which contain six types of the LED chips are arranged on the top surface of the heat conducting base 1 as shown in Fig. 8c. Each type of the LED chips contain two chips emitting lights at different wavelengths. As illustrated in Fig.8c, the twelve LED chips 5 are arranged in stagger way to allow a good light mixing. The six types of LED chips are the blue light LED chip with the peak wavelength of 457nm, the blue green light LED chip with the peak wavelength of 490nm, the green light LED chip with the peak wavelength of 525nm, the yellow green light LED chip with the peak wavelength of 560nm, the orange light LED chip with the peak wavelength of 590nm and the red light LED chip with the peak wavelength of 630nm. They are arranged in such a manner that the intervals between the peak wavelengths of any two adjacent LED chips are about 35nm. The twelve (six types of) LED chips are divided into two groups. The chips in each group are connected in series and are lead out by lead strips which are connected to the driving power supply, as shown in Fig.8c.

Referring to Fig.8d, another white LED with high CRI comprises nine types of LED chips emitting lights at different wavelengths (only one chip for each type). Use of the nine types of LED chips emitting lights at different wavelengths can improve the smoothness in the energy profile of the spectrum of the LED to approach the energy profile of the spectrum of the standard lamp. The nine types of the chips employ the peak wavelengths of 457nm, 465nm, 490nm, 515nm, 535nm, 560nm, 590nm, 610nm and 630nm respectively. They are arranged on the heat conducting base 1 so that the light can be mixed well. The nine chips are divided into two groups. The first group contains five LED chips with substantially shorter wavelengths, i.e., it is comprised of five LED chips with the wavelengths of 457nm, 535nm, 560nm, 465nm and 490nm respectively, which are connected in series. The second group contains four LED chips with substantially longer wavelengths, i.e., it is comprised of four LED chips with the wavelengths of 590nm, 630nm, 515nm and 610nm, which are connected in series. The two groups of chips connected in series respectively are lead out respectively by lead out strips which are connected to driving circuit 8. Since the numbers of the chips in the two groups are different, two independent power supplies are required to drive the two groups of chips respectively. Although use of two power supplies may increase the complexity of the electrical circuits, the current in each group can be adjusted independently, which is beneficial to adjusting the CRI of the LED. The total number of the chips may depend on the necessary power for working and the capacity of withstand power in each chip, as appreciated by the skilled person in the art.

Compared with the combination of six types of chips emitting lights at different wavelengths, the combination of nine chips further contains a blue light LED chip with the wavelength of 465nm between 457nm and 490nm, a LED chip with the wavelength of 515nm between 490nm and 535nm and a LED chip with the wavelength of 610nm between 590nm and 630nm. In the combination of six types of chips, the energy distributions for the spectra of the chips with the wavelengths of 490nm and 457nm are overlapped at the wavelength at which the output powers of the chips are 1/4 of the peak value of power as the interval between 490nm and 457nm is 33nm. Having inserted the chip with the wavelength of 465nm, the interval between the peak wavelengths 465nm and 457nm becomes 8nm and the interval between the peak wavelengths 465nm and 490nm becomes 25nm. Thus, the energy distributions of the spectra for the chip with the wavelength of 465nm and for the chip with the wavelength of 490nm or 457nm are overlapped at the wavelength at which the output powers of the chips are not more than 1/2 of the peak value of power. As a result, the energy distribution overlapped in the wavelength range of 457nm∼490nm substantially becomes a horizontal line with approximately equal powers throughout the wavelength range. Similarly, the LED chip with the wavelength of 515nm between 490nm and 535nm can reduce the intervals between the adjacent peak wavelengths from 45nm to 25nm and 20nm, respectively. The LED chip with the wavelength of 610nm between 590nm and 630nm can reduce the intervals between the adjacent peak wavelengths from 40nm to 20nm. Therefore, the energy distributions of the spectra for the chip with the wavelength of 515nm and for the chip with the wavelength of 490nm or 535nm are overlapped at the wavelength at which the output powers of the chips are not more than 1/2 of the peak value of power and the energy distributions of the spectra for the chip with the wavelength of 610nm and for the chip with the wavelength of 590nm or 630nm are also overlapped at the wavelength at which the output powers of the chips are not more than 1/2 of the peak value of power. Although the chip with the wavelength of 560nm and the chip with the wavelength of 590nm have the interval of 30nm for the peak wavelengths so that the energy distribution overlapped in the wavelength range of 560nm∼590nm has a lower output power, it will not nearly affect the energy distribution in its entirety. When the nine types of the chips work simultaneously, the energy distribution of the spectrum becomes relatively smooth. The total number of the chips may depend on the necessary power for working and the capacity of bearing power in each chip, as appreciated by the skilled person in the art.

The size of the LED chips mentioned in the embodiment may be small, such as 0.35mm×0.35mm, or may be large, such as 1mm×1mm or 1.5mm×1.5mm. The number of each chip may be determined based on the desired power level of the white LED.

### Embodiment 2

Referring Fig.9, a LED lamp with high CRI will be described.

The LED lamp employs any one of the above white LEDs 11 according to the present invention as its light source. The white LEDs 11 are fixed directly on the top of the heat sink 13 to allow quick heat dissipation when the chip 5 works. The heat sink 13 is a common one used in the general LED lamp. If the luminous flux of a white LED fails to meet the requirements, a plurality of white LEDs with high CRI described according to the present invention will be used, as appreciated by the skilled person in the art. The white LED(s) is(are) surrounded by a conical reflecting cover 3'. The angle between the reflecting cover 3' and fixing plane for the white LED is in the range of 10°∼80°. Projections 4' are provided on the inner wall of the reflecting cover 3'. The projections 4' can mix the lights and allow the light to exit at desired angles. The conical reflecting cover 3' may also be fixed on the top of the heat sink 13. The heat sink 13 is made of high thermal conductivity materials and is provided with fins on the outer surface, as shown in Fig.9. The heat sink 13 provides good air convection and high efficiency of heat dissipation. The top size of the heat sink 13 is suitable to be fitted to the reflector. The bottom of the heat sink 13 is connected with a cup-shaped plastic member 14 within which the driving circuit 8 is provided. The plastic member 14 ensures enough electrical insulation between the driving circuit 8 and the heat sink 13. The plastic member 14 is provided with an electrical connector 10 at its end. The electrical connector 10 may comprises a screw-socket in a common E27 or E14, or a bayonet socket in double or multiple feet. The white LEDs may be fixed in the center of said reflecting cover and the bottom surface of the white LEDs may abut against the heat sink which is provided with fins and has sizes fitted to the reflecting cover. The white LED(s) may be mechanically in contact with the heat sink by the screws or screw holes on the heat conducting base. The lead of the LED(s) is electrically connected to the driving circuit 8. The driving circuit 8 is electrically connected with the electrical connector 10 by its housing. A transparent bubble shell 12 covers the LED(s). The transparent bubble shell 12 may be a colored or light diffused bubble shell made of common glass or plastic, or may be coated with a layer of light conversion material on the inner wall of the transparent bubble shell.

### Embodiment 3

A LED plane light source used for indoor lighting is also provided in the present invention.

Referring to Fig.10, the LED plane light source for indoor lighting is similar to a common LED plane light source except the heat sink which is a radiation plate provided with two or four reflecting walls. The radiation plate has a bottom surface provided with fins. The inner surfaces of the reflecting walls are provided with projections 4'. Any one or more of the white LEDs 11 with high CRI according to the invention (the number of the LEDs depends on the desired luminous flux) are fixed directly on the top surface of the heat sink. An electrical connector 10, e.g., an electrical connecting hole on the outer side of the reflecting wall is connected to the driving circuit 8. The transparent bubble shell 12 is fixed on the reflecting wall to achieve a separated plane light source. The radiation plates may be arranged on the back face of the light guide plate used for the plane light source or back lighting source for a LCD (liquid crystal display) and surrounding the light guide plate. Since the white light emitted from the LED is reflected repeatedly by its bottom and sides and exits from its top surface finally, so, the output light is quite uniform.

Although the above description has explained some specific embodiments, the present invention may be implemented in other embodiments. The skilled person in the art would appreciate that all of modifications and variations of the above embodiments fall within the scope of the present invention without departing from the concept of the present invention.

## Claims

1. A white LED with high CRI including:
a heat conducting base (1);
a lead frame (2);
a reflector (3) fixed on a top surface of said heat conducting base (1);
LED chips (5) fixed on said heat conducting base (1) and in said reflector (3) and
a transparent silicone (6) covering upper surfaces of said LED chips (5),
wherein said reflector (3) is a conical cup having an open bottom, and
wherein said lead frame (2) has a size which is fitted to the bottom of said reflector (3) and is fixed outside the bottom of said reflector (3) and on the top surface of said heat conducting base (1),
**characterized in that** spherical protrusions (4) with a smooth surface for mixing light are provided on an inner wall surface of the reflector (3) and that said LED chips(5) comprise at least six types of LED chips (5) emitting lights at different peak wavelengths, each type of LED chips (5) including at least one chip, and said LED chips (5) are arranged and combined electrically on said heat conducting base in such a manner that an interval of peak wavelengths of two adjacent LED chips (5) is 20nm - 35nm, said LED chips (5) further comprising electrodes electrically connected to leads on said lead frame (2).

2. The white LED with high CRI according to claim 1, wherein said LED chips (5) comprise nine types of LED chips (5) emitting lights at respective nine peak wavelengths which are 457nm, 465nm, 490nm, 515nm, 535nm, 560nm, 590nm, 610nm and 630nm, respectively, said nine LED chips (5) being divided into a first group which is composed of five LED chips (5) emitting lights at peak wavelengths of 457nm, 535nm, 560nm, 465nm and 490nm respectively connected in series and a second group which is composed of four LED chips (5) emitting lights at peak wavelengths of 590nm, 630nm, 515nm and 610nm respectively connected in series, and
wherein the two groups of LED chips (5) connected in series have respective leads for connecting respective driving circuits (8).

3. The white LED with high CRI according to claim 1, wherein said heat conducting base (1) is a plate base made of copper, aluminum or other high-thermal conductivity materials, a base provided with a type of radiation assembly or radiation fins which are spiral radiation fins with one or more spirals, or a base provided with a screw or screw hole on its bottom surface, said radiation assembly being composed of a support made of high-thermal conductivity materials, top radiation ribs arranged on the top of the support and a group of lower radiation ribs surrounding the support, the support being a super heat conducting pipe, a metal pipe or a metal rod, and
wherein the radiation ribs are provided with a through hole in its center, which has a diameter that is equal to outer diameter of the super heat conducting pipe, the metal pipe or the metal rod, the super heat conducting pipe or the metal pipe having an inner diameter which is capable of being fitted to the screw on the bottom surface of the heat conducting base (1) of the LEDs, and
wherein a porous or net-like housing made of insulating materials or metal encloses the support and become a part of the support.

4. The white LED with high CRI according to claim 1, wherein said reflector (3) is made of metal material of copper or aluminum.

5. The white LED with high CRI according to claim 1, wherein said protrusions (4) have same or different diameters, said protrusions (4) being arranged in stagger way in alternate lines, in arrays or uniform pattern in descending order of sizes.

6. A white LED with high CRI including:
a heat conducting base (1);
a lead frame (2);
a reflector (3) fixed on a top surface of said heat conducting base (1);
LED chips (5) fixed on said heat conducting base (1) and in said reflector (3) and
a transparent silicone (6) covering upper surfaces of said LED chips (5),
wherein said reflector (3) is a conical cup having an open bottom, and
wherein said lead frame (2) has a size which is fitted to the bottom of said reflector (3) and is fixed outside the bottom of said reflector (3) and on the top surface of said heat conducting base (1),
**characterized in that** spherical protrusions (4) with a smooth surface for mixing light are provided on an inner wall surface of the reflector (3) and that said LED chips (5) comprise at least six types of LED chips (5) emitting lights at different peak wavelengths, each type of LED chips (5) including at least one chip, and said LED chips (5) are arranged and combined electrically on said heat conducting base, said LED chips (5) further comprising electrodes electrically connected to leads on said lead frame (2), wherein said LED chips (5) comprise six types of LED chips (5) emitting lights at respective six peak wavelengths which are 457nm for a blue light, 490nm for a blue green light, 525nm for a green light, 560nm for a yellow green light, 590nm for an orange light and 630nm for a red light, respectively, said LED chips (5) being electrically connected in series, in parallel or in a combination of series connection and parallel connection and having leads electrically connected to a driving power supply, and wherein said LED chips (5) are divided into groups, each group of said LED chips (5) being connected in series and having leads electrically connected to a driving circuit (8).

7. A white LED lamp, comprising:
at least one white LED according to claim 1 or 6;
a transparent bubble shell (12);
a heat sink (13);
a driving circuit (8);
an electrical connector (10); and
a transparent silicone (6),
wherein said white LED lamp further comprises a reflecting cover (3') which is a conical cup having an open bottom and is provided with projections (4') on its inner wall surface, said reflecting cover (3') being fixed on the top of said heat sink (13), said at least one white LED being fixed in the center of said reflecting cover (3') and the bottom surface of said at least one white LED abuts against said heat sink (13) which is provided with fins and has sizes fitted to the reflecting cover (3'), and
wherein said electrodes of said at least one white LED are connected to the driver via wires from the lead frame (2), and
wherein said heat sink (13) has a bottom connected with a cup-shaped plastic member (14) within which a driving power supply is accommodated, the plastic member (14) being provided with an electrical connector (10) at its end.

8. The white LED lamp according to claim 7, wherein said electric connector (10) is a screw-socket, preferably an international standard screw-socket of E27 or E14, or a bayonet socket in double or multiple feet.

9. The white LED lamp according to claim 7, wherein said transparent bubble shell (12) is a transparent, colored or light diffused bubble shell made of glasses or plastics, or is coated with a layer of light conversion material on the inner wall of the transparent bubble shell (12).

10. A LED lighting plane source used for indoor lighting comprising:
at least one white LED with high CRI according to claim 1 or 6;
a heat sink (13);
a driving circuit(8);
an electrical connector (10); and
a transparent bubble shell (12),
wherein, said heat sink (13) is a radiation plate provided with two or four reflecting walls, the radiation plate having a bottom surface provided with fins, inner surfaces of the reflecting walls being provided with projections (4'), at least one of the reflecting walls being provided with an electrical connecting hole on its outer side, the electrical connecting hole being connected to the driving circuit (8), and
wherein the transparent bubble shell (12) is fixed on the reflecting walls to achieve a separated plane light source, or at least two LED plane light sources are combined.

## Patentansprüche

1. Eine weiße LED mit einem hohen Farb-Rendering-Index, die aufweist:
eine wärmeleitende Basis (1);
einen Leitungsrahmen (2);
einen Reflektor (3), der auf einer Oberseite der wärmeleitenden Basis (1) fixiert ist;
LED-Chips (5), die auf der wärmeleitenden Basis (1) und in dem Reflektor (3) fixiert sind, und
transparentes Silikon (6), das obere Flächen der LED-Chips (5) bedeckt,
wobei der Reflektor (3) eine konische Schale mit einem offenen Boden ist, und
wobei der Leitungsrahmen (2) eine Größe aufweist, die an den Boden des Reflektors angepasst ist und die außerhalb des Bodens des Reflektors (3) und an der Oberseite der wärmeleitenden Basis (1) fixiert ist,
**dadurch gekennzeichnet, dass** sphärische Vorsprünge (4) mit einer glatten Oberfläche zum Mischen von Licht an einer inneren Wandfläche des Reflektors (3) vorgesehen sind, und dass die LED-Chips (5) zumindest sechs Typen von LED-Chips (5) aufweisen, die Licht bei unterschiedlichen maximalen Wellenlängen emittieren, wobei jeder LED-Chip-Typ (5) zumindest einen Chip aufweist, und wobei die LED-Chips (5) auf der wärmeleitenden Basis so angeordnet und elektrisch kombiniert sind, dass ein Intervall von maximalen Wellenlängen von zwei benachbarten LED-Chips (5) 20nm ∼ 35nm beträgt, wobei die LED-Chips (5) des Weiteren Elektroden aufweisen, die elektrisch mit Leitungen des Leitungsrahmens (2) verbunden sind.

2. Die weiße LED mit einem hohen Farb-Rendering-Index nach Anspruch 1, wobei die LED-Chips (5) neun Typen von LED-Chips (5) aufweisen, die Licht bei jeweils neun maximalen Wellenlängen emittieren, nämlich bei 457nm, 465nm, 490nm, 515nm, 535nm, 560nm, 590nm, 610nm bzw. 630nm, wobei die neun LED-Chips (5) eine erste Gruppe, die aus fünf LED-Chips (5) besteht, die Licht bei maximalen Wellenlängen von 457nm, 535nm, 560nm, 465nm bzw. 490nm emittiert und die in Serie verbunden sind, und eine zweite Gruppe aufweist, die aus vier LED-Chips (5) besteht, die Licht bei maximalen Wellenlängen von 590nm, 630nm, 515nm bzw. 610nm emittieren und die in Serie verbunden sind, und
wobei die zwei Gruppen von LED-Chips (5), die in Serie verbunden sind, jeweils Leitungen zum Verbinden jeweiliger Ansteuerschaltungen (8) aufweisen.

3. Die weiße LED mit einem hohen Farb-Rendering-Index nach Anspruch 1, wobei die wärmeleitende Basis (1) eine Plattenbasis ist, die aus Kupfer, Aluminium oder anderen Materialien hoher Wärmeleitfähigkeit hergestellt ist, wobei eine Basis mit einem Typ einer Strahlungsanordnung oder Strahlungsfinnen vorgesehen ist, die Spiralstrahlungsfinnen mit einer oder mehreren Spiralen sind, oder eine Basis mit einer Schraube oder einem Schraubenloch in ihrer Bodenfläche vorgesehen ist, wobei die Strahlungsanordnung aus einer Halterung aus Materialien mit einer hohen Wärmeleitfähigkeit besteht, wobei obere Strahlungsrippen auf der Oberseite der Halterung angeordnet sind, und wobei eine Gruppe unterer Strahlungsrippen die Halterung umgibt, wobei die Halterung ein superwärmeleitendes Rohr, ein Metallrohr oder ein Metallstab ist, und
wobei die Strahlungsrippen mit einem Durchgangsloch in ihrer Mitte versehen sind, das einen Durchmesser aufweist, der gleich einem Außendurchmesser des superwärmeleitenden Rohrs, des Metallrohrs oder des Metallstabs ist, wobei das superwärmeleitende Rohr oder das Metallrohr einen Innendurchmesser aufweist, der an die Schraube in der Bodenfläche der wärmeleitenden Basis (1) der LEDs angepasst werden kann, und
wobei ein poröses oder netzähnliches Gehäuse, das aus isolierenden Materialien oder Metall hergestellt ist, die Halterung umschließt und ein Teil der Halterung wird.

4. Die weiße LED mit einem hohen Farb-Rendering-Index nach Anspruch 1, wobei der Reflektor (3) aus einem metallischen Material aus Kupfer oder Aluminium hergestellt ist.

5. Die weiße LED mit einem hohen Farb-Rendering-Index nach Anspruch 1, wobei die Vorsprünge (4) gleiche oder unterschiedliche Durchmesser aufweisen, wobei die Vorsprünge (4) in alternierenden Linien in Anordnungen oder in gleichförmigen Mustern mit abfallender Größenordnung angeordnet sind.

6. Eine weiße LED mit einem hohen Farb-Rendering-Index, die aufweist. eine wärmeleitende Basis (1);
einen Leitungsrahmen (2);
einen Reflektor (3), der an einer Oberseite der wärmeleitenden Basis (1) fixiert ist; LED-Chips (5), die auf der wärmeleitenden Basis (1) und in dem Reflektor (3) fixiert sind, und
transparentes Silikon (6), das obere Flächen der LED-Chips (5) bedeckt,
wobei der Reflektor (3) eine konische Schale mit einem offenen Boden ist, und wobei der Leitungsrahmen (2) eine Größe aufweist, die an dem Boden des Reflektors (3) angepasst ist, und der außerhalb des Bodens des Reflektors (3) und an der Oberfläche der wärmeleitenden Basis (1) fixiert ist,
**dadurch gekennzeichnet, dass** sphärische Vorsprünge (4) mit einer glatten Oberfläche zum Mischen von Licht an einer inneren Wandfläche des Reflektors (3) vorgesehen sind, und dass die LED-Chips (5) zumindest sechs Typen von LED-Chips (5) aufweisen, die Licht bei unterschiedlichen maximalen Wellenlängen emittieren, wobei jeder Typ der LED-Chips (5) zumindest einen Chip umfasst, und wobei die LED-Chips (5) auf der wärmeleitenden Basis angeordnet sind und elektrisch verbunden sind, wobei die LED-Chips (5) des Weiteren Elektroden aufweisen, die elektrisch mit Leitungen an dem Leftungsrahmen (2) verbunden sind, wobei die LED-Chips (5) sechs Typen von LED-Chips (5) aufweisen, die Licht bei jeweils sechs maximalen Wellenlängen emittieren, nämlich bei 457nm für blaues Licht, 490nm für blaugrünes Licht, 525nm für grünes Licht, 560nm für gelbgrünes Licht, 590nm für orangenes Licht bzw. 640nm für rotes Licht, wobei die LED-Chips (5) seriell, parallel oder in einer Kombination einer seriellen Verbindung und einer parallelen Verbindung verbunden sind und Leitungen aufweisen, die elektrisch an eine steuernde Energieversorgung angeschlossen sind, und wobei die LED-Chips (5) in Gruppen aufgeteilt sind, wobei jede Gruppe aus LED-Chips (5) seriell verbunden ist und Leitungen aufweist, die elektrisch mit einer Steuerschaltung (8) verbunden sind.

7. Eine weiße LED-Lampe, die aufweist:
zumindest eine weiße LED nach einem der Ansprüche 1 oder 6;
eine transparente Blasenhülle (12);
eine Wärmesenke (13);
eine Steuerschaltung (8);
eine elektrische Verbindungseinrichtung (10); und
transparentes Silikon,
wobei die weiße LED-Lampe des Weiteren eine reflektierende Abdeckung (3') aufweist, die eine konische Schale mit einem offenen Boden darstellt und die mit Vorsprüngen (4') an ihrer inneren Wandfläche versehen ist, wobei die reflektierende Abdeckung (3') an der Oberseite der Wärmesenke (13) fixiert ist, wobei zumindest eine weiße LED in der Mitte der reflektierenden Abdeckung (3') fixiert ist, und wobei die Bodenfläche der zumindest einen weißen LED gegen die Wärmesenke (13) anstößt, die mit Finnen versehen ist und die Größen aufweist, die an die reflektierende Abdeckung (3') angepasst sind und
wobei die Elektroden der zumindest einen weißen LED mit der Steuereinrichtung über Drähte von dem Leitungsrahmen (2) verbunden sind, und
wobei die Wärmesenke (13) einen Boden aufweist, der mit einem schalenförmigen Kunststoffglied (14) verbunden ist, in welchem eine Steuerenergieversorgung untergebracht ist, wobei das Kunststoffglied (14) mit einer elektrischen Verbindungseinrichtung (10) an ihrem Ende versehen ist.

8. Die weiße LED-Lampe nach Anspruch 7, wobei die elektrische Verbindungseinrichtung (10) eine Einschraubfassung, vorzugsweise eine Einschraubfassung des internationalen Standards E27 oder E14, oder eine Bajonett-Fassung mit zwei oder mehreren Füßen ist.

9. Die weiße LED-Lampe nach Anspruch 7, wobei die transparente Blasenhülle (12) eine transparente, farbige oder lichtbrechende Blasenhülle aus Glas oder Kunststoff ist, oder die mit einer Schicht aus einem lichtumwandelnden Material an der inneren Wand der transparenten Blasenhülle (12) beschichtet ist.

10. Eine LED-Beleuchtungsebenenquelle, die zur Innenbeleuchtung verwendet wird, aufweisend:
zumindest eine weiße LED mit hohem Farb-Rendering-Index nach einem der Ansprüche 1 oder 6;
eine Wärmesenke (13);
eine Steuerschaltung (8);
eine elektrische Verbindungseinrichtung (10); und
eine transparente Blasenhülle (12),
wobei die Wärmesenke (13) eine Strahlungsplatte mit zwei oder vier Reflektorwänden ist, wobei die Strahlungsplatte eine mit Finnen versehene Bodenfläche aufweist, wobei Innenflächen der Reflektorwände mit Vorsprüngen (4) versehen sind, wobei zumindest eine der Reflektorwände mit einem elektrischen Verbindungsloch an seiner Außenseite versehen ist, wobei das elektrische Verbindungsloch mit der Steuerschaltung (8) verbunden ist, und
wobei die transparente Blasenhülle (12) an den Reflektorwänden fixiert ist, um eine getrennte, ebene Lichtquelle zu erhalten, oder wobei zumindest zwei LED-Ebenenlichtquellen verbunden sind.

## Revendications

1. LED blanche possédant un IRC élevé, et comprenant :
- une base conductrice de chaleur (1);
- un cadre de conducteurs (2) ;
- un réflecteur (3) fixé sur une surface supérieure de ladite base conductrice de chaleur (1) ;
- des puces à LED (5) fixées sur ladite base conductrice de chaleur (1) et dans ledit réflecteur (3), et un silicone transparent (6) couvrant les surfaces supérieures desdites puces à LED (5) ;
- dans laquelle ledit réflecteur (3) est une coupelle conique ayant un fond ouvert ; et
- dans laquelle ledit cadre de conducteurs (2) possède une taille adaptée au fond dudit réflecteur (3) et est fixé à l'extérieur du fond dudit réflecteur (3) et sur la surface supérieure de ladite base conductrice de chaleur (1) ;
- **caractérisée en ce que** des protubérances sphériques (4) ayant une surface lisse pour mélanger la lumière sont disposées sur une surface de paroi interne du réflecteur (3), et **en ce que** lesdites puces à LED (5) comprennent au moins six types de puces à LED (5) émettant des lumières à différentes longueurs d'onde pics, chaque type de puces à LED (5) comprenant au moins une puce, et lesdites puces à LED (5) sont disposées et combinées électriquement sur ladite base conductrice de chaleur de sorte qu'un intervalle de longueurs d'onde pics de deux puces à LED (5) adjacentes soit de 20 nm - 35 nm, lesdites puces à LED (5) comprenant en outre des électrodes connectées électriquement aux conducteurs sur ledit cadre de conducteurs (2).

2. LED blanche possédant un IRC élevé selon la revendication 1, dans laquelle lesdites puces à LED (5) comprennent neuf types de puces à LED (5) émettant des lumières à neuf longueurs d'onde pics respectives de 457 nm, 465 nm, 490 nm, 515 nm, 535 nm, 560 nm, 590 nm, 610 nm et 630 nm, respectivement, lesdites neuf puces à LED (5) étant divisées en un premier groupe qui comprend cinq puces à LED (5) émettant des lumières à des longueurs d'onde pics de 457 nm, 535 nm, 560 nm, 465 nm et 490 nm, respectivement connectées en série, et en un second groupe qui comprend quatre puces à LED (5) émettant des lumières à des longueurs d'onde pics de 590 nm, 630 nm, 515 nm et 610 nm, respectivement connectées en série ; et
- dans laquelle les deux groupes de puces à LED (5) connectées en série ont des conducteurs respectifs pour connecter des circuits d'actionnement respectifs (8).

3. LED blanche possédant un IRC élevé selon la revendication 1, dans laquelle ladite base conductrice de chaleur (1) est une base plate faite de cuivre, d'aluminium ou d'autres matériaux ayant une conductivité thermique élevée, une base comportant un type de système de rayonnement ou d'ailettes de rayonnement consistant en des ailettes de rayonnement spiralées comprenant une ou plusieurs spirales, ou une base comprenant une vis ou un trou de vis sur sa surface inférieure, lequel système de rayonnement comprend un support fait de matériaux à conductivité thermique élevée, des nervures de rayonnement supérieures disposées sur le dessus du support et un groupe de nervures de rayonnement inférieures entourant le support, le support étant un tube super-conducteur de chaleur, un tube métallique ou une tige métallique ; et
- dans laquelle les nervures de rayonnement comprennent un trou traversant en leur centre, lequel possède un diamètre qui est égal au diamètre externe du tube super-conducteur de chaleur, du tube métallique ou de la tige métallique, le tube super-conducteur de chaleur ou le tube métallique ayant un diamètre interne leur permettant d'être insérés sur la vis sur la surface inférieure de la base conductrice de chaleur (1) des LED ; et
- dans laquelle un boîtier poreux ou de type filet fait de matériaux isolants ou de métal entoure le support et fait partie de celui-ci.

4. LED blanche possédant un IRC élevé selon la revendication 1, dans laquelle ledit réflecteur (3) est fait d'un matériau métallique à base de cuivre ou d'aluminium.

5. LED blanche possédant un IRC élevé selon la revendication 1, dans laquelle lesdites protubérances (4) ont des diamètres identiques ou différents, lesquelles protubérances (4) sont disposées en quinconce en lignes alternantes, en réseau ou selon un motif uniforme dans l'ordre décroissant de leur taille.

6. LED blanche possédant un IRC élevé, comprenant :
- une base conductrice de chaleur (1);
- un cadre de conducteurs (2) ;
- un réflecteur (3) fixé sur une surface supérieure de ladite base conductrice de chaleur (1) ;
- des puces à LED (5) fixées sur ladite base conductrice de chaleur (1) et dans ledit réflecteur (3), et
un silicone transparent (6) couvrant les surfaces supérieures desdites puces à LED (5) ;
- dans laquelle ledit réflecteur (3) est une coupelle conique ayant un fond ouvert ; et
- dans laquelle ledit cadre de conducteurs (2) possède une taille adaptée au fond dudit réflecteur (3) et est fixé à l'extérieur du fond dudit réflecteur (3) et sur la surface supérieure de ladite base conductrice de chaleur (1) ;
- **caractérisée en ce que** des protubérances sphériques (4) ayant une surface lisse pour mélanger la lumière sont disposées sur une surface de paroi interne du réflecteur (3), et **en ce que** lesdites puces à LED (5) comprennent au moins six types de puces à LED (5) émettant des lumières à différentes longueurs d'onde pics, chaque type de puces à LED (5) comprenant au moins une puce, et lesdites puces à LED (5) sont disposées et combinées électriquement sur ladite base conductrice de chaleur, lesdites puces à LED (5) comprenant en outre des électrodes connectées électriquement aux conducteurs sur ledit cadre de conducteurs (2), dans laquelle lesdites puces à LED (5) comprennent six types de puces à LED (5) émettant des lumières à six longueurs d'onde pics respectives de 457 nm pour une lumière bleue, 490 nm pour une lumière bleue-verte, 525 nm pour une lumière verte, 560 nm pour une lumière jaune-verte, 590 nm pour une lumière orange, et 630 nm pour une lumière rouge, respectivement, lesdites puces à LED (5) étant connectées électriquement en série, en parallèle ou selon une combinaison de connexion série et de connexion parallèle et ayant des conducteurs connectés électriquement à une alimentation électrique d'actionnement, et dans laquelle lesdites puces à LED (5) sont divisées en groupes, chaque groupe desdites puces à LED (5) étant connecté en série et comprenant des conducteurs connectés électriquement à un circuit d'actionnement (8).

7. Lampe à LED blanches comprenant :
- au moins une LED blanche selon la revendication 1 ou 6 ;
- une enceinte à bulles transparente (12) ;
- un dissipateur thermique (13) ;
- un circuit d'actionnement (8) ;
- un connecteur électrique (10) ; et
- un silicone transparent (6) ;
- laquelle lampe à LED blanches comprenant en outre un cache réfléchissant (3') qui est une coupelle conique possédant un fond ouvert et comportant des protubérances (4') sur sa surface de paroi interne, lequel cache réfléchissant (3') est fixé sur le dessus dudit dissipateur thermique (13), ladite au moins une LED blanche étant fixée au centre dudit cache réfléchissant (3') tandis que la surface inférieure de ladite au moins une LED blanche entre en butée contre ledit dissipateur thermique (13) qui comprend des ailettes et possède des dimensions adaptées au cache réfléchissant (3') ; et
- dans laquelle lesdites électrodes de ladite au moins une LED blanche sont connectées à l'actionneur via des fils provenant du cadre de conducteurs (2) ; et
- dans laquelle ledit dissipateur thermique (13) comprend un fond connecté à un élément plastique en forme de coupelle (14) dans lequel est disposée une alimentation électrique d'actionnement, l'élément plastique (14) comportant un connecteur électrique (10) à son extrémité.

8. Lampe à LED blanches selon la revendication 7, dans laquelle ledit connecteur électrique (10) est une douille à vis, de préférence une douille à vis répondant à la norme internationale E27 ou E14, ou une douille à baïonnette en deux pieds ou plus.

9. Lampe à LED blanches selon la revendication 7, dans laquelle ladite enceinte à bulles transparente (12) est une enceinte à bulles transparente, colorée ou à lumière diffuse faite de verres ou de plastiques, ou est couverte d'une couche de matériau de conversion de lumière sur la paroi interne de l'enceinte à bulles transparente (12).

10. Source plane d'éclairage à LED pour éclairage intérieur, comprenant :
- au moins une LED blanche possédant un IRC élévé selon la revendication 1 ou 6 ;
- un dissipateur thermique (13) ;
- un circuit d'actionnement (8) ;
- un connecteur électrique (10) ; et
- une enceinte à bulles transparente (12) ;
- dans laquelle ledit dissipateur thermique (13) est une plaque de rayonnement comprenant deux ou quatre parois réfléchissantes, laquelle plaque de rayonnement comprend une surface inférieure comportant des ailettes, tandis que les surfaces internes des parois réfléchissantes comportent des protubérances (4'), au moins une des parois réfléchissantes comprend un trou de connexion électrique sur son côté externe, le trou de connexion électrique étant connecté au circuit d'actionnement (8) ; et
- dans laquelle l'enceinte à bulles transparente (12) est fixée sur les parois réfléchissantes afin d'obtenir une source de lumière plane séparée, ou au moins deux sources de lumière planes à LED sont combinées.
